Europäisches Patentamt

European Patent Office

Office européen des brevets

(11) Veröffentlichungsnummer: **0 107 033
B1**

# (12) EUROPÄISCHE PATENTSCHRIFT

(45) Veröffentlichungstag der Patentschrift:
24.06.87

(51) Int. Cl.⁴: **G 01 R 19/04**

(21) Anmeldenummer: **83109275.4**

(22) Anmeldetag: **19.09.83**

(54) **Amplitudendetektor für impulsförmige Signale mit hoher Impulsfolgefrequenz.**

(30) Priorität: **23.09.82 DE 3235254**

(43) Veröffentlichungstag der Anmeldung:
**02.05.84 Patentblatt 84/18**

(45) Bekanntmachung des Hinweises auf die Patenterteilung:
**24.06.87 Patentblatt 87/26**

(84) Benannte Vertragsstaaten:
**AT BE CH DE FR GB IT LI**

(56) Entgegenhaltungen:
**DE - A - 3 106 477
DE - B - 2 801 704**

**"Sourcebook of Electronic Circuits", Mc Graw-Hill
Book Company, 1968, Seiten 533 bis 536**

(73) Patentinhaber: **Siemens Aktiengesellschaft Berlin und
München, Wittelsbacherplatz 2, D-8000 München 2 (DE)**

(72) Erfinder: **Meyer, Fritz, Dr. Ing., Wifostrasse 5,
D-8034 Germering (DE)**

### Beschreibung

Die Erfindung betrifft einen Amplitudendetektor der an seinem Ausgang eine Gleichspannung abgibt, die der jeweiligen Amplitude der Eingangswechselspannung entspricht und der einen ersten Transistor enthält, dessen Emitteranschluss mit einem Signaleingang in Verbindung steht, dessen Basisanschluss über die Parallelschaltung eines Kondensators und eines Widerstandes und dessen Kollektoranschluss über einen Widerstand jeweils an Bezugspotential angeschlossen ist.

Ein Amplitudendetektor der vorstehend erwähnten Art ist aus der DE-B-2 801 704 bekannt. Der bekannte Amplitudendetektor enthält ebenfalls einen ersten Transistor, dessen Emitteranschluss mit dem Signaleingang in Verbindung steht, dessen Basisanschluss über die Parallelschaltung eines Kondensators und eines Widerstandes an Bezugspotential angeschlossen ist und dessen Kollektoranschluss über einen weiteren Widerstand mit Bezugspotential verbunden ist. Der bekannte Amplitudendetektor löst das Problem, das insbesondere bei niederfrequenten Signalspannungen die erzeugte Gleichspannung entweder eine zu grosse Welligkeit aufweist oder Amplitudenänderungen nicht schnell genug erfolgt.

Im vorliegenden Falle besteht demgegenüber das Problem, einen Amplitudendetektor für digitale Signale mit Bitraten von über 100 Mbit/s zu entwickeln, wie sie beispielsweise in Sendestufen von digitalen Übertragungsstufen auftreten, es kann sich auch um entsprechend schnelle analoge Signale mit Frequenzmodulation oder Impulsdauermodulation handeln, wie sie beispielsweise als Modulationssignal von Laserdioden optischer Übertragungsstrecken auftreten.

Amplitudendetektoren für entsprechend schnelle Signale sind in Form der HF-Tastköpfe aus der HF-Messtechnik bekannt. Bei diesen Tastköpfen werden einfache Spitzenwertgleichrichter verwendet, die im Hinblick auf die hohen Signalfrequenzen mit Schottky-Dioden bestückt sind. Schaltungen mit Schottky-Dioden sind aber gegen impulsförmige Überspannungen mit kurzer Anstiegszeit sehr empfindlich, ohne dass ein ausreichender Schutz, beispielsweise durch Parallelbegrenzer mit Siliziumdioden, wegen deren geringer Verarbeitungsgeschwindigkeit möglich ist. Durch ausreichend bemessene Schutzwiderstände für die Schottky-Dioden fällt aber die Ausgangsspannung der Amplitudendetektoren stark ab, so dass zusätzliche Stufen für Nachverstärkung und Pegelanpassung erforderlich sind.

Die Aufgabe bei der vorliegenden Erfindung besteht also darin, einen temperaturkompensierten Amplitudendetektor der eingangs erwähnten Art zu schaffen, der mit sehr geringem Aufwand realisiert werden kann, da die Amplitudendetektoren in jedem Zwischenregenerator einer digitalen Übertragungsstrecke zur Überwachung der Sendeamplitude benötigt werden; wegen der Fernspeisung der Zwischengeneratoren darf der Amplitudendetektor ausserdem nur einen sehr geringen Strom aufnehmen, die Belastung und Verformung des Sendesignals durch die Stromaufnahme des Amplitudendetektors muss vernachlässigbar klein sein und ausserdem sollte der Amplitudendetektor im Hinblick auf den Einsatz am Kabelanschluss der Zwischenregeneratoren Überspannungen in der Grössenordnung von $\pm 10\,V$ unbeschadet aufnehmen.

Erfindungsgemäss wird die Aufgabe dadurch gelöst, dass zur Verarbeitung impulsförmiger Signale hoher Impulsfolgefrequenz an dem Signaleingang für die impulsförmigen Signale über eine Reihenschaltung aus einem ersten Widerstand und einem ersten Kondensator der Emitteranschluss des ersten Transistors angeschlossen ist, dass der Kollektoranschluss dieses Transistors mit einem Ausgangsanschluss und über eine Parallelschaltung eines zweiten Widerstandes und eines zweiten Kondensators mit Bezugspotential verbunden ist, dass der Emitteranschluss des ersten Transistors über einen vierten Widerstand mit der Betriebsspannung verbunden ist und dass der Basisanschluss des ersten Transistors über eine erste Diode und einen fünften, einstellbaren Widerstand mit Betriebsspannung verbunden ist. Der erfindungsgemässe Amplitudendetektor ist in besonders vorteilhafter Weise geeignet, ohne Zwischenstufen zur Pegelanpassung direkt MOS-Schaltungen zur Signalverarbeitung anzusteuern, so dass der Gesamtaufwand und die gesamte Stromaufnahme des Zwischenregenerators durch diese Zusatzeinrichtung nicht wesentlich erhöht werden. Zur Vermeidung von Schwingungen im Ausgangssignal des Amplitudendetektors ist eine Weiterbildung zweckmässig, bei der die Übertragungskennlinie eine Hysterese aufweist, die sich dadurch ergibt, dass mit dem Kollektoranschluss des ersten Transistors der Basisanschluss eines zweiten Transistors verbunden ist, dessen Emitteranschluss über einen dritten Widerstand mit dem Emitteranschluss des ersten Transistors verbunden ist und dass der Kollektoranschluss des zweiten Transistors direkt mit Bezugspotential verbunden ist.

Die Erfindung soll im folgenden anhand der Zeichnung näher erläutert werden. In der Zeichnung zeigt:

Fig. 1 die Schaltung eines Amplitudendetektors nach der Erfindung und

Fig. 2 Übertragungskennlinien des Amplitudendetektors nach Fig. 1.

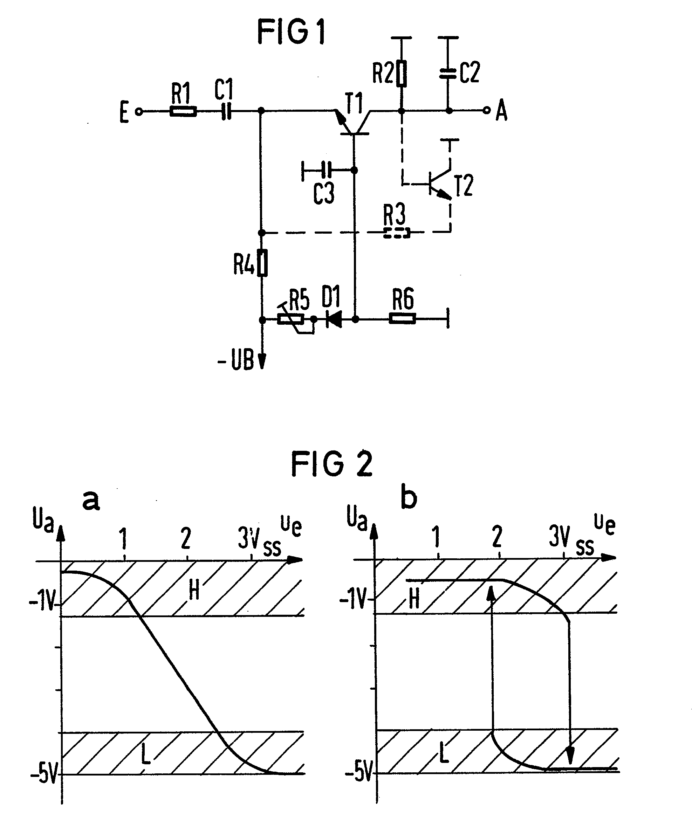

An den Eingang E des Amplitudendetektors nach der Fig. 1 ist über eine Reihenschaltung eines ersten Widerstandes R1 und eines ersten Kondensators C1 ein Emitteranschluss eines ersten Transistors T1 angeschlossen. Der Kollektoranschluss dieses Transistors ist mit einem Ausgangsanschluss A des Amplitudendetektors verbunden, ausserdem besteht über die Parallelschaltung eines zweiten Widerstandes R2 und eines zweiten Kondensators C2 eine Verbindung zum Bezugspotential. Der Basisanschluss des ersten Transistors T1 ist über einen dritten Kondensator C3 mit Bezugspotential verbunden, ausserdem ist der Basisanschluss an einen Mittelabgriff eines aus einem fünften Widerstand R5 und einem sechsten Widerstand R6 gebildeten Basisspannungsteilers angeschlossen. Der fünfte Widerstand R5 ist ausserdem an eine Betriebsspannungsquelle –UB angeschlossen, die ausserdem über einen vierten Widerstand R4 mit dem Emitteranschluss des ersten Transistors T1 verbunden ist. In den Basisspannungsteiler ist, unmittelbar an den fünften Widerstand R5 angeschlossen, eine Diode D1 zur Temperaturkompensation eingefügt.

Der HF-Transistor T1 in der Schaltung nach Fig. 1 ist in Basisschaltung betrieben, die Basisvorspannung ist dabei so gewählt, dass ohne zusätzliches Signal der Transistor gerade zu leiten beginnt, aber nur ein sehr geringer Kollektorstrom fliesst. Aufgrund der erwähnten Basisvorspannung bleiben die eingekoppelten positiven Impulse praktisch ohne Wirkung, durch die negativen Impulse wird dagegen der Transistor T1 voll in den leitenden Zustand gesteuert. Von dem eingekoppelten Eingangssignal treten daher nur die negativen Spannungsimpulse verstärkt am Kollektorwiderstand R2 auf. Durch den Kondensator C2 wird daraus der Gleichanteil ausgesiebt und steht am Ausgang A zur Ansteuerung einer MOS-Signalverarbeitungsschaltung zur Verfügung.

Die Übertragungskennlinie entsprechend der Fig. 2a gibt den Verlauf des Ausgangspegels $U_a$ als Funktion der Eingangsamplitude $u_e$ an. Bei einem zu geringen Wert der Eingangsamplitude $u_e$ entsprechend einem zu geringen Wert der Sendeamplitude des beispielsweise angeschlossenen Zwischenregenerators ergibt sich der Logikzustand H, während mit steigender Eingangsamplitude schliesslich der Logikzustand L erreicht wird. Aufgrund der Temperaturkompensation des Basisspannungsteilers des Amplitudendetektors nach Fig. 1 durch die Diode D1 ist diese Übertragungskennlinie in weiten Bereichen praktisch temperaturunabhängig. Der Übergangsbereich zwischen den beiden Logikpegeln kann durch geeignete Wahl der Basisvorspannung, die durch den Widerstand R5 zu verändern ist, zu grösseren oder kleineren Eingangsamplituden verschoben werden.

In der Schaltung nach der Fig. 1 dient der Transistor T1 gleichzeitig als Gleichrichter, Verstärker und zur Pegelanpassung, so dass keine empfindlichen Schottky-Dioden benötigt werden. Der Überspannungsschutz für den Transistor T1 ergibt sich durch den relativ hochohmigen Vorwiderstand R1 in Verbindung mit dem Kondensator C1, wobei durch den Widerstand R1 gleichzeitig die Belastung des zu überwachenden Signals verkleinert wird.

Im Hinblick auf eine stabile Arbeitsweise ist es bei derartigen Amplitudendetektoren wünschenswert, dass die Übertragungskennlinie eine Hysterese aufweist. Zur Erzeugung eines derartigen Verhaltens ist in der Schaltung nach der Fig. 1 gestrichelt ein zweiter Transistor T2 eingefügt, dessen Basisanschluss mit dem Kollektoranschluss des ersten Transistors direkt, dessen Emitteranschluss mit dem Emitteranschluss des ersten Transistors T1 über einen dritten Widerstand und dessen Kollektoranschluss mit Bezugspotential verbunden ist. Durch diesen zusätzlichen Transistor, der nur für die Verstärkung von NF-Signalen geeignet sein muss, ist der Amplitudendetektor nach der Fig. 1 so stark rückgekoppelt, dass sich die in Fig. 2b dargestellte Kennlinie mit Hysterese ergibt. Die Lage dieser Übertragungskennlinien kann dabei wiederum durch geeignete Wahl der Basisvorspannung des Transistors T1 verschoben werden, der Rückkopplungsgrad und damit die Breite des Hystereseabschnittes der Übertragungskennlinie wird durch den Widerstandswert des Widerstandes R3 festgelegt und kann mit diesem zusammen entsprechend verändert werden.

**Patentansprüche**

1. Amplitudendetektor, der an seinem Ausgang eine Gleichspannung abgibt, die der jeweiligen Amplitude der Eingangswechselspannung entspricht und der einen ersten Transistor (T1) enthält, dessen Emitteranschluss mit einem Signaleingang (E) in Verbindung steht, dessen Basisanschluss über die Parallelschaltung eines Kondensators (C3) und eines Widerstandes (R6) und dessen Kollektoranschluss über einen Widerstand (R2) jeweils an Bezugspotential angeschlossen ist, dadurch gekennzeichnet, dass zur Verarbeitung impulsförmiger Signale hoher Impulsfolgefrequenz an dem Signaleingang (E) für die impulsförmigen Signale über eine Reihenschaltung aus einem ersten Widerstand (R1) und einem ersten Kondensator (C1) der Emitteranschluss des ersten Transistors (T1) angeschlossen ist, dass der Kollektoranschluss dieses Transistors mit einem Ausgangsanschluss (A) und über eine Parallelschaltung eines zweiten Widerstandes (R2) und eines zweiten Kondensators (C2) mit Bezugspotential verbunden ist, dass der Emitteranschluss des ersten Transistors über einen vierten Widerstand (R4) mit der Betriebsspannung (−UB) verbunden ist, und dass der Basisanschluss des ersten Transistors (T1) über eine erste Diode (D1) und einen fünften einstellbaren Widerstand (R5) mit Betriebsspannung (−UB) verbunden ist.

2. Amplitudendetektor nach Patentanspruch 1, dadurch gekennzeichnet, dass mit dem Kollektoranschluss des ersten Transistors (T1) der Basisanschluss eines zweiten Transistors (T2) verbunden ist, dessen Emitteranschluss über einen dritten Widerstand (R3) mit dem Emitteranschluss des ersten Transistors (T1) verbunden ist und dass der Kollektoranschluss des zweiten Transistors (T2) direkt mit Bezugspotential verbunden ist.

**Claims**

1. An amplitude detector, which at its output emits a d.c. voltage corresponding to the respective amplitude of the input a.c. voltage, and which contains a first transistor (T1) whose emitter is connected to a signal input (E), whose base is connected to reference potential via the parallel arrangement of a capacitor (C3) and a resistor (R6), and whose collector is connected to reference potential via a resistor (R2), characterised in that for processing signals in the form of pulses which have a high pulse repetition frequency the emitter of the first transistor (T1) is connected to the pulse signal input (E) via a series arrangement of a first resistor (R1) and a first capacitor (C1), that the collector of this transistor is connected to an output terminal (A), and to reference potential via a parallel arrangement of a second resistor (R2) and a second capacitor (C2), that the emitter of the first transistor is connected via a fourth resistor (R4) to the operating voltage (−UB), and that the base of the first transistor (T1) is connected to the operating voltage (−UB) via a first diode (D1) and a fifth, adjustable resistor (R5).

2. An amplitude detector as claimed in Claim 1, characterised in that the collector of the first transistor (T1) is connected to the base of a second transistor (T2) whose emitter is connected via a third resistor (R3) to the emitter of the first transistor (T1), and that the collector of the second transistor (T2) is directly connected to reference potential.

## Revendications

1. Détecteur d'amplitude qui délivre sur sa sortie une tension continue qui correspond à l'amplitude respective de la tension alternative d'entrée, et contient un premier transistor (T1), dont la borne d'émetteur est reliée à une entrée (E) des signaux et dont la borne de base et la borne de collecteur sont reliées, respectivement par l'intermédiaire du circuit parallèle formé d'un condensateur (C3) et d'une résistance (R6) et par l'intermédiaire d'une résistance (R2), au potentiel de référence, caractérisé par le fait que pour le traitement de signaux en forme d'impulsions, dont la fréquence de récurrence est élevée, la borne d'émetteur du premier transistor (T1) est raccordée à l'entrée (E) d'arrivée des signaux en forme d'impulsions, par l'intermédiaire d'un circuit série formé d'une première résistance (R) et d'un condensateur (C1), que la borne de collecteur de ce transistor est reliée à une borne de sortie (A) et, par l'intermédiaire d'un circuit parallèle formé d'une seconde résistance (R2) et d'un second condensateur (C2), au potentiel de référence, et que la borne d'émetteur du premier transistor est reliée à la tension de fonctionnement (−UB) par l'intermédiaire d'une quatrième résistance (R4) et que la borne de base du premier transistor (T1) est reliée par l'intermédiaire d'une première diode (D1) et d'une cinquième résistance réglable (R5) à la tension de fonctionnement (−UB).

2. Détecteur d'amplitude suivant la revendication 1, caractérisé par le fait qu'à la borne du collecteur du premier transistor (T1) se trouve raccordée la borne de base d'un second transistor (T2), dont la borne d'émetteur est reliée par l'intermédiaire d'une troisième résistance (R3) à la borne d'émetteur du premier transistor (T1), et que la borne de collecteur du second transistor (T2) est reliée directement au potentiel de référence.

# FIG 1

# FIG 2